(19) Europäisches Patentamt
European Patent Office
Office européen des brevets

(11) **EP 0 727 822 B1**

(12) **EUROPEAN PATENT SPECIFICATION**

(45) Date of publication and mention
of the grant of the patent:
**11.08.1999 Bulletin 1999/32**

(51) Int Cl.⁶: **H01L 29/788**, H01L 29/51,
H01L 21/336, H01L 27/112,
G11C 17/00

(21) Application number: **96300693.7**

(22) Date of filing: **31.01.1996**

(54) **Semiconductor memory device**

Halbleiter-Speicheranordnung

Dispositif semi-conducteur de mémoire

(84) Designated Contracting States:
**DE FR GB IT NL**

(30) Priority: **14.02.1995 JP 2539295**

(43) Date of publication of application:
**21.08.1996 Bulletin 1996/34**

(73) Proprietor: **CANON KABUSHIKI KAISHA
Tokyo (JP)**

(72) Inventor: **Okita, Akira, c/o Canon K.K.
Tokyo (JP)**

(74) Representative:
**Beresford, Keith Denis Lewis et al
BERESFORD & Co.
2-5 Warwick Court
High Holborn
London WC1R 5DJ (GB)**

(56) References cited:
**EP-A- 0 500 034          EP-A- 0 510 607
EP-A- 0 550 404          EP-A- 0 682 370
US-A- 4 146 902          US-A- 5 365 094**

• **PATENT ABSTRACTS OF JAPAN vol. 001, no.
050 (E-020), 16 May 1977 & JP-A-51 147135 (NEC
CORP), 17 December 1976,**

## Description

The present invention concerns solid state memory apparatus, particularly programmable read-only memory arrays and memory devices incorporating such arrays.

One-Time Programmable Read-Only Memories (OT-PROMS), which permit only one writing, are disclosed in Japanese Laid-open Patent Application No. 62-188260 and Japanese Laid-open Patent Application No. 62-49651. In the structures therein disclosed the wiring metal is connected in series with a main electrode (the source or the drain in the case of MOSFET (Metal Oxide Semiconductor Field Effect Transistor) or the emitter in the case of a bipolar transistor of a transistor through a Si region the crystal structure of which is destroyed, or through an a-Si layer. Storage operation is carried out by changing the Si region or the a-Si layer from a high-resistance state to a low-resistance state.

Further, the above proposed OT-PROMS are excellent in properties of keeping states after writing permanently unchanged and stabilized, but they have required, for example, an a-Si layer and a contact region between the a-Si layer and wiring for each bit. In the semiconductor process, formation of contact holes is more difficult than formation of linear patterns. The contact size, if using a 0.8 $\mu$m rule process for linear patterning, is of the order of 1 $\mu$m$^2$ (1 $\mu$m x 1 $\mu$m), about 20 percent up. Since the wiring width needs to be increased for compatibility with the size of the contact holes, an optimum decrease in the area per bit cannot be achieved. It thus becomes difficult to increase the memory capacity with these memories proposed. Further, because a large current flows in the above a-Si layer in writing operation, dissipation power is high and applications to portable devices are difficult, which are points desired to be improved.

Japanese Patent Application JP-A-51-147135 discloses an OT-PROM array having the features recited in the preamble of claim 1. In the memory cells of that array the floating gate has a portion overlying the channel and source of the storage insulated gate transistor. It is separated by a thin region of insulator which serves as an antifuse. When the cell is written this antifuse region is fused to provide a short circuit between the floating gate and the source.

The memory array of the present invention, defined by the appended claim, provides an alternative and is characterised in that:

each memory cell has an antifuse region defined by a high resistance thin film, interposed between said control gate and said floating gate, on
one or both of the edge surfaces of said floating gate which extend in a direction parallel to said channel, or
the sidewall surface of said floating gate located in an opening provided in said integrate insulation layer and in said floating gate.

It is acknowledged that European Patent Application EP-A-0682370, mentioned here with reference to Article 54(3)EPC, discloses an OT-PROM array which in addition to those features recited in the preamble of claim 1 includes an antifuse region interposed between the control gate and the floating gate. The antifuse region in that case, however, is provided by the intergate insulator layer and has no predetermined position relative to the edges of the floating gate. The writing operation described is similar to that discussed herein.

It is also acknowledged that EP-A-0500034 discloses a structure in which an antifuse region is provided on the edge surface or sidewall surface of one conductor and is located between that conductor and another conductor. It is applied, for example, in the construction of programmable gate arrays. The antifuse is programmed by providing a voltage above a breakdown threshold which causes a large current to pass through the antifuse region (a thin film dielectric layer) between the two conductive layers. As a result, a conductive connection between the two conductive layers is permanently established. The conductive layers may be of polysilicon, titanium, tungsten, molybdenum, platinum, titanium silicide, tungsten silicide, molybdenum silicide, platinum silicide, titanium nitride and combinations thereof. The dielectric layer may be, for example, of silicon oxynitride. A typical thickness of the dielectric thin film is 6.5 nm.

The aforesaid memory array can be designed to have a large storage capacity, and can be manufactured at a low cost. In operation it can exhibit high writing speed and high reading speed, high reliability, and low power dissipation.

The aforesaid memory can be fabricated with only a small number of fabrication steps, and so can be fabricated at high yield and low cost. It can be integrated on the same chip as circuits, which, in addition to driver circuits, can include circuits constituting memory device parts of another type, such as SRAM or DRAM, and/or logic circuits to provide a high-functional design of chip.

The aforesaid memory array can be used not only as a memory medium for a computer, but also as a memory medium for other purposes, for example, for audio or video data storage and can be used to replace audio tapes, video tapes or CD-ROM, which are commercially available at present, utilizing the above high-performance characteristics.

The aforesaid memory array has application to systems permitting a user to carry or to extract and store data such as video data in an easy fashion by writing in a recording medium such as a card, having a memory array of the present invention, outputs from external memory apparatus in portable devices, electronic publishing, control apparatus, and electronic video and image memories, for example from still videos, facsimile devices, and copiers.

In the accompanying drawings:

Figs. 1 to 3 are illustrations of a first embodiment of the invention in which part of a memory array is shown in plan in Fig. 2 and in section in Figs. 1 and 3 for section lines 1-1 and 3-3 of Fig. 2;
Figs. 4A to 7B are diagrammatic sectional and plan views to illustrate steps in the manufacture of the first embodiment;
Fig. 8 is a schematic equivalent circuit diagram of a memory device incorporating the memory array of the first embodiment;
Figs. 9 and 10 are timing charts for explaining operation of the memory device of Fig. 8;
Fig. 11 is a diagrammatic sectional view of part of a memory array illustrating a second embodiment of the invention;
Figs. 12A and 12B are diagrammatic sectional views to illustrate stages in the manufacture of the second embodiment;
Figs. 13 and 14 are a diagrammatic plan view and a diagrammatic sectional view for sectional line 14-14 of Fig. 14, of part of a memory array illustrating a third embodiment of the invention;
Fig. 15 is a schematic equivalent circuit diagram of another memory device incorporating a memory array embodying the present invention;
Fig. 16 is a schematic system block diagram of a computer system using a PC card; and
Fig. 17 is a schematic perspective view of a PC card incorporating memory devices.

In order to facilitate a better understanding of the invention, preferred embodiments thereof will now be described in particular detail with reference to the drawings. The following description is given by way of example only.

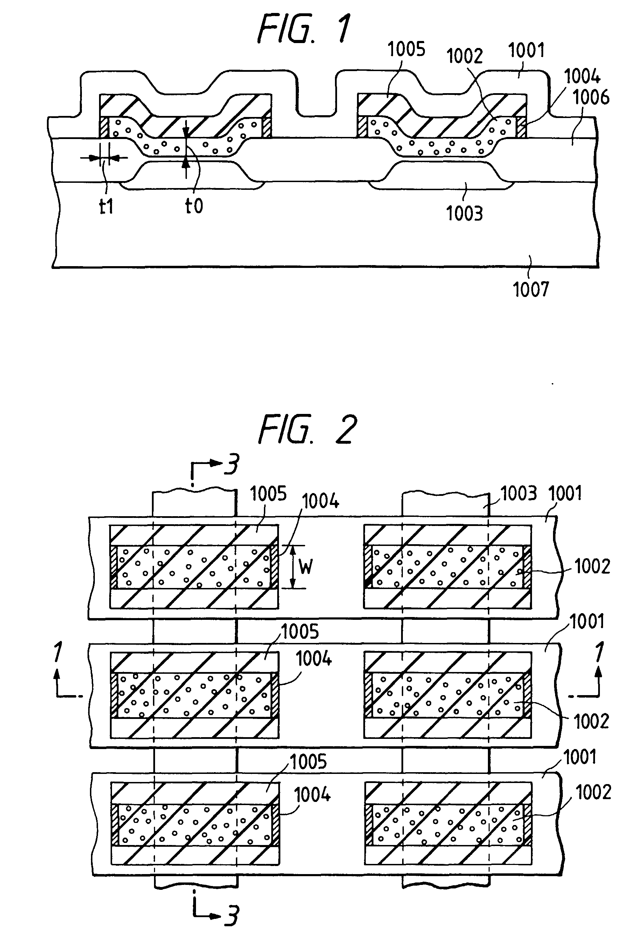

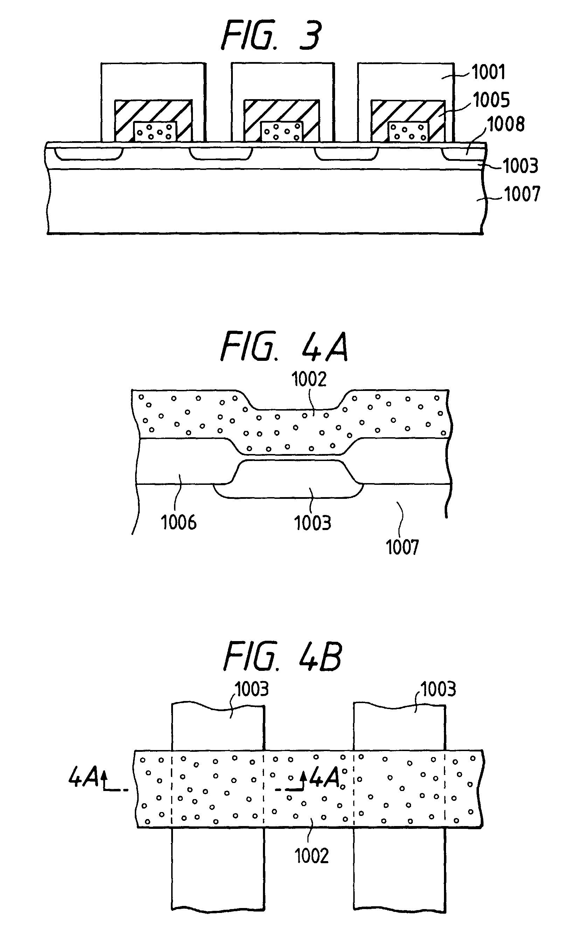

A memory array, as first embodiment of the invention, is shown in part in Figs. 1 to 3 of the drawings. In these figures, reference numeral 1001 designates a control gate, 1002 a floating gate, 1003 a MOSFET well layer, 1004 an antifuse region of high-resistance thin film, 1005 an intergate insulating layer, 1006 an insulating layer, and 1007 a bulk semiconductor substrate. In Fig. 3 numeral 1008 denotes either a source or a drain. Although in this example the control gate overlies the floating gate and channel, this structure is not always essential, and the control gate may be formed overlying only the high resistance thin film 1004 provided at one or both ends of the floating gate.

In Fig. 2 the insulating layer 1006 is omitted in order to avoid complexity of illustration, and the well layer 1003 is schematically shown therein. As for discrimination between solid lines and dashed lines, the figure is illustrated as giving priority to easiness to see in order to avoid complexity. It is thus noted that the portions represented by solid lines in Fig. 2 are not always exposed in the outermost surface. Since positional relations between the layers and between the portions can be understood from Fig. 1 and Fig. 3, reference should be made to them in order to understand the relations.

Conditions for changing the antifuse region between the control gate and the floating gate from a high-resistance state to a low-resistance state, will now be explained.

It is sufficient that $V_{BD}$ is low and $C_{CG}$ is small (where $V_{BD}$ is the breakdown between the floating gate and the control gate when the resistance between the control gate and the floating gate changes from a high-resistance state into a low-resistance state and $C_{CG}$ is the capacitance between the floating gate and the control gate).

In order to lower $V_{BD}$, the separation (T) between the control gate and the floating gate is made smaller so as to increase the intensity of the electric field between the control gate and the floating gate. Then, in order to make $C_{CG}$ smaller while keeping the separation (T) small, the area of the region of the smallest separation (T), where the control gate is closest to the floating gate, should be decreased.

The memory array, part of which is shown in Figs. 1 to 3 has a structure suitable for satisfying the above conditions, since the high-resistance thin film 1004 is formed on the end edge surfaces of the floating gate 1002, and the control gate 1001 is formed with a portion in contact therewith, thus defining the major component of the capacitance $C_{CG}$. This structure allows the high-resistance thin film to be formed as thin as possible and as small in area as possible, thus satisfying the conditions that $V_{BD}$ is low and $C_{CG}$ is small.

In this example, the capacitance $C_{CG}$ between the floating gate 1002 and the control gate 1001 is mainly determined by the thickness t1 (shown in Fig. 1) and the area s1 of the high-resistance thin film 1004. The area s1 of the high-resistance thin film 1004 is determined by the product of the line width W (shown in Fig. 2) of the floating gate 1002 and the film thickness t0 (shown in Fig. 1) thereof. The line width W is limited by the technology of photolithography (to a width of at least 0.3 μm at present), but the film thickness t0 of the floating gate, for example if the floating gate is formed by depositing polySi by the LPCVD process, can be as small as 0.01 μm (100 Å), which is less than the width defined by state of the art photolithography and variations thereof can be controlled adequately within 1%. The floating gate may be made of a high-melting-point silicide such as tungsten silicide. The film thickness tl is preferably selected in the range of (1 to 30 nm) (10 to 300 Å), further preferably in the range of 3 to 20 nm (30 to 200 Å), and more preferably in the range of 5 to 15 nm (50 to 150 Å). This thickness is properly selected depending upon the voltage applied for changing the antifuse region to the low-resistance state. The thickness should be not less than 5 nm (50 Å) from the viewpoint of maintaining sure electric insulation and not more than 15 nm (150 Å) in order to lower the voltage applied, which are the reasons for the more preferred range of thickness.

As explained, the film thickness tO of the floating gate 1002, which is a factor for determining the area sl of the high-resistance thin film 1004, is independent of the limitations of photolithography, so that it can be determined to be small with extremely good accuracy and, therefore, the area sl of the high-resistance thin film 1004 also can be determined to be small with extremely good accuracy. Since the film thickness t1 of the high-resistance thin film 1004 can be set by the deposition conditions of film, it is free of the limitations of photolithography.

The capacitance $C_{CG}$ mainly determined by the film thickness t1 and the area sl of the high-resistance thin film 1004 can be determined to be small with extremely good accuracy accordingly.

On the other hand, the breakdown voltage $V_{BD}$ between the floating gate 1002 and the control gate 1001 is mainly determined by the film thickness tl of the high-resistance thin film 1004. Thus, the voltage can be decreased by making the high-resistance thin film 1004 thinner. The antifuse region 1004 of the present invention is a region where the resistance changes with application of a voltage of value not less than the breakdown voltage, and this antifuse region of thin film does not have to remain as a thin film on being changed to the low-resistance state. The essential requirement is that electrical conduction is achieved between the gates.

A preferred example of a method of forming the above described memory array is next described referring to Figs. 4A to 7B.

First, a p-type Si substrate 1007 was prepared. The p-type Si substrate 1007 may be one containing impurities at an impurity concentration level of $10^{14}$ to $10^{17}$ $cm^{-3}$, of which a level of $10^{16}$ $cm^{-3}$ is preferred from the view points of optimising well separation width and well capacitance. Then, as shown in Figs. 4A and 4B a field oxide film 1006 for separation of memory cells was formed by the process of local oxidation of silicon or modified local oxidation of silicon (in which after grooves are formed by etching Si where the field oxide film is to be formed, silicon is oxidized, whereby bird's beaks become narrow, thus narrowing the separation width). After that, mask patterning was conducted and then ion implantation was carried out to form n-type wells 1003 containing impurities at an impurity concentration about 2 to 7 times greater than that of the substrate. In this case, the depth of the wells was determined to be at the same level as the bottom of the field oxide film 1006 in order to ensure a withstand voltage between n well and n well, and the wells were thus considerably shallower than ordinary wells. After that, a thermal oxide film 8.5 nm was formed (85 Å) thick by wet oxidation at 750°C to 1100°C and then was subjected to a thermal treatment including a treatment in an $NH_3$ atmosphere at

950°C to 1100°C for 90 seconds and a treatment in an $O_2$ atmosphere or $N_2O$ atmosphere at 1150°C for 90 seconds, thereby forming an SiON film having an effective thickness of about 10 nm (100 Å). After that, a first layer of polySi 1002 of thickness 400 nm (4000 Å) was formed, by LPCVD (Low Pressure Chemical Vapour Deposition) This first polySi layer may be modified to form a silicide or polyide by putting a refractory metal such as W, Ti, Ta, or Mo on the layer and thereafter annealing it, or the refractory metal selected therefrom may be used instead of the first polySi. Use of these low-resistance materials can decrease the film thickness of the floating gate, so that the capacitance of $C_{FG}$ also can be decreased in addition to achieving flatness thereof. These silicide (or polyide ) and refractory metal layers can be treated to form an insulating layer, for example, by oxidation or nitridation. Particularly, use of Ta is preferred, because it becomes $Ta_2O_5$ by oxidation which has a property of high electric insulation, and can be readily changed into a low resistance state.

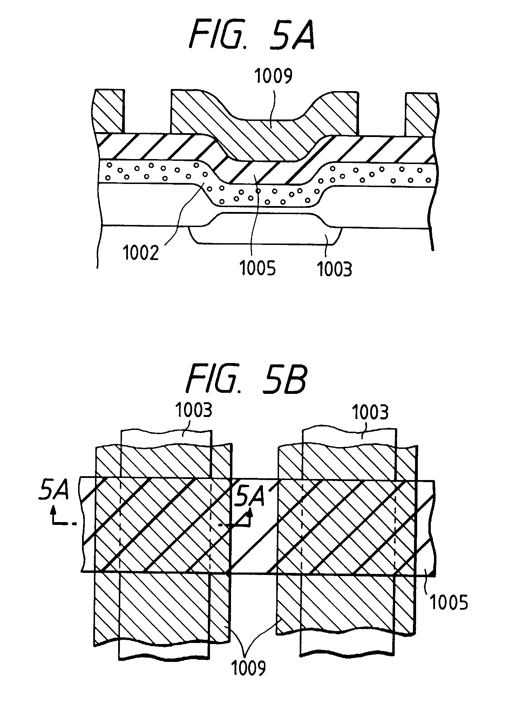

Next, ion implantation and annealing was carried out to dope the above polySi with impurities, and gate electrodes were formed by patterning the first polySi layer. On this occasion, patterns of polySi are formed each in a shape connected in the direction of lines 4A - 4A, 5A - 5A shown in Figs. 4B and 5B. Next, using this polySi, the source and drain regions of a PMOSFET were formed in a self-aligned manner by ion implantation (not shown). It is preferred to employ an LDD structure or a GOLD structure in order to relieve the electric field at the source and drain edges in the cases of scale down.

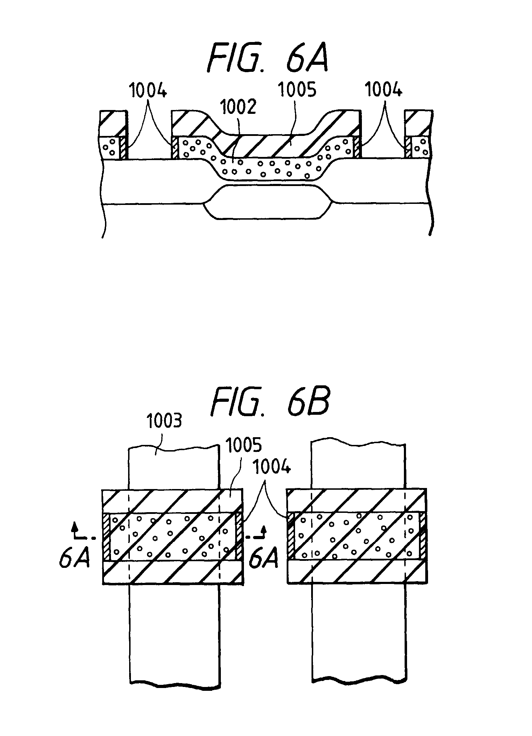

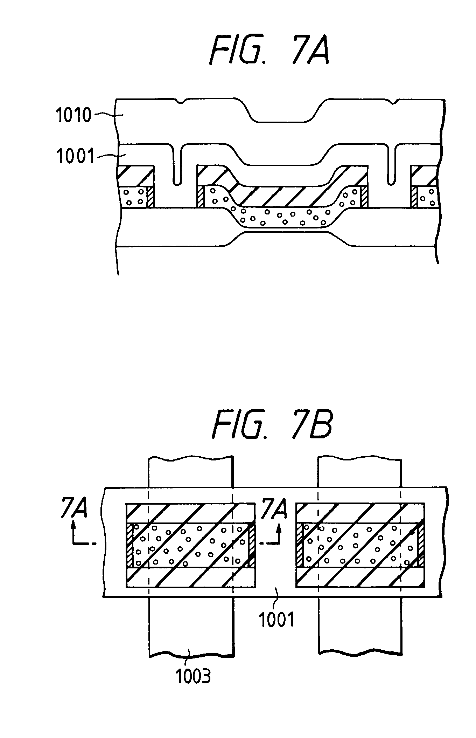

Next, as shown in Fig. 5A and Fig. 5B, the polySi layer 1002 was subjected to wet oxidation at 950°C to form a $SiO_2$ layer 1005 of thickness 200 nm (2000 Å). Then a resist layer mask 1009 was produced and the $SiO_2$ layer 1005 and polySi layer 1002 were anisotropically etched in succession, and-thereafter the resist was removed. Next, as shown in Figs. 6A and 6B, the very thin thin film 1004 was formed on the edge surface of the polySi layer exposed by the above etching. In this case, the high-resistance thin film may be produced by dry oxidation at a temperature for example of 800°C, or by forming a chemically oxidized film of about 1 to 5 nm (10 to 50 Å) thickness in a bath of pure water including an additive of ozone ($O_3$) or of an acid (e.g. ($H_2SO_4$, HCL) solution including an additive of hydrogen peroxide; or of an alkali (e.g. ($NH_4OH$) solution; and thereafter thermally treating it in an inert gas atmosphere such as high-purity Ar or $N_2$ at 500°C to 600°C for 30 minutes. After that, as shown in Fig. 7A and Fig. 7B, a second layer of polySi was formed on the wafer again by LPCVD, and word lines 1001, forming, and providing connection between, the control gates, were formed by doping with impurity and patterning in the same manner as in the previous process. If the word lines are long, it is preferred to use a metal polyside (or metal silicide) containing a metal, for example W-polyside (tungsten polyside) or the like, in order to decrease the resistance. The high-resistance thin film may be made of a material selected from silicon nitrides, or inorganic oxides, for example oxides or oxynitrides of silicon and $Ta_2O_5$.

When the high-resistance layer region 1004 was formed in this manner between the control gate 1001 and the floating gate 1002, $C_{CG}$ was formed with very good accuracy and repeatability, as explained previously. It is, however, noted herein that the $SiO_2$ layer 1005 is formed by oxidizing the polySi layer 1002 and, therefore, it becomes thinner than the thickness of the initial polySi layer.

Thereafter formed in the same manner as in the ordinary LSI process were an interlayer insulation layer 1010 for example of BPSG or the like, contacts (not shown), metal wiring (not shown), and a passivation film, and then pad portions (not shown) were patterned, thus concluding the process. The number of masks used for forming the above structure is not more than a half of that necessary for fabricating normal memories, such as DRAM, SRAM, and flash $E^2PROM$. The memory cells thus formed each have a small area per bit and can be formed by very simple steps with a high yield, thus reducing manufacturing cost.

The description of the fabrication process of the present structure concerned the single-side well structure, but, without having to be limited to it, it is of course effective to employ the double well structure of n-type well and p-type well, formation of a channel stop layer in separating portions, and trench separation in some cases.

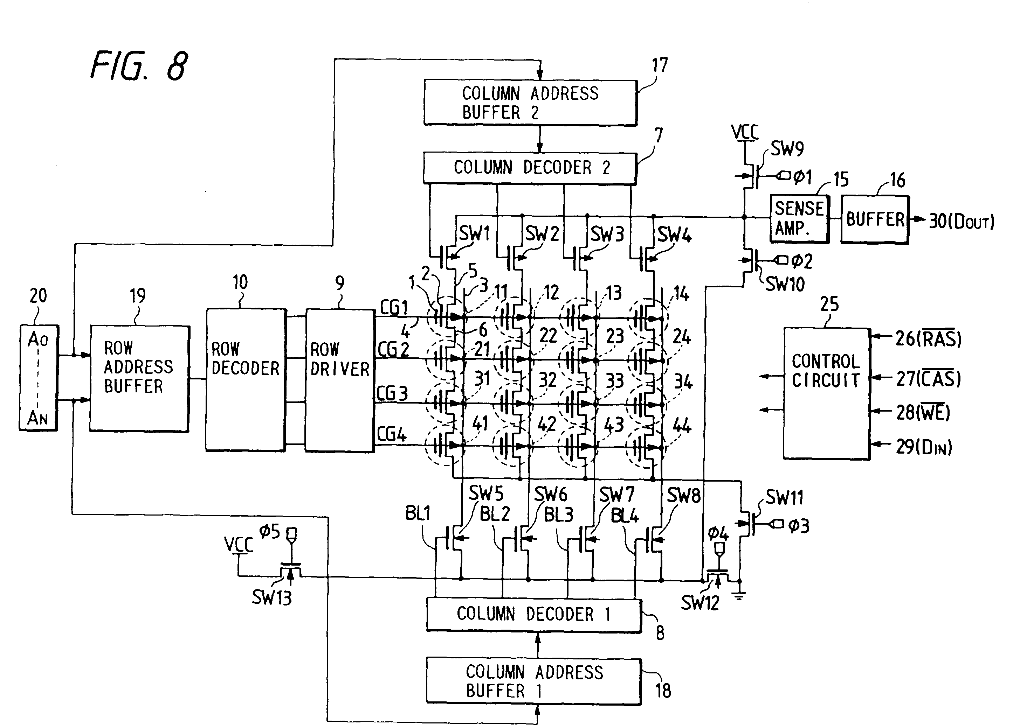

Fig. 8 shows an example of an equivalent block circuit of a memory device incorporating a memory array embodying the present invention. In Fig. 8, numerals 11, 12, 13, 14, 21, 22, 23, 24, 31, 32, 33, 34, 41, 42, 43, 44 each denote memory cells of its array, and here is shown a case of a 4 × 4 cell structure for convenience' sake of explanation.

In a memory cell, numeral 1 designates the control gate, 2 the floating gate, 3 the well layer, 4 the word line to which each control gate is connected, and 5, 6 the source and drain respectively.

The sources and drains of the cells are connected in series with each other in each column. Numeral 7 represents a column decoder for selecting a readout column-, 8 a column decoder for selecting a writing bit line, 9 a row driver for driving the word lines, 10 a row decoder for selecting the word lines, 15 a sense amplifier, and 16 a buffer amplifier. Further, numerals 17, 18 denote column address buffers, which transmit to the column decoders 7, 8 addresses from an input 20. SW1 to SW13 are MOSFET switches, and the switches SW9, SW10, SW11 SW12, SW13 are controlled by pulses $\phi1$, $\phi2$, $\phi3$, $\phi4$, $\phi5$. Numeral 26 stands for a row address strobe ($\overline{RAS}$), 27 for a column address strobe ($\overline{CAS}$), 28 for a write enable ($\overline{WE}$), 29 for an input data signal ($D_{IN}$), and 30 for an output data signal ($D_{OUT}$).

The operation of this memory device is next explained. This device is arranged to receive two types of address signals input through a common input pin in time division. After a column address becomes definite, the column address is taken into the chip by inputting $\overline{CAS}$ denoted by 27 from high level to low level. Then, after a row address becomes definite, the row address is taken into the chip by inputting $\overline{RAS}$ denoted by 26 from high level to low level. This arrangement can reduce by half the number of pins for address. Whether the chip is in a reading state or in a writing state is determined by whether the $\overline{WE}$ signal denoted by 28 is high level or low level.

In the reading mode, effective output data is obtained from the $D_{OUT}$ terminal denoted by 30 a certain time after $\overline{RAS}$. In the writing mode data is written through the $D_{IN}$ terminal denoted by 29.

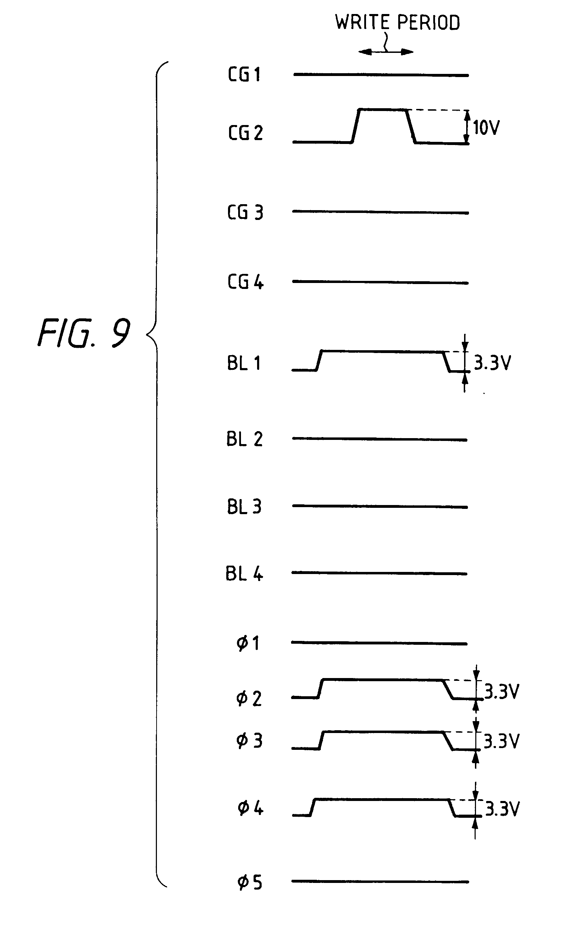

A writing operation is next explained in detail referring to the schematic timing chart shown in Fig. 9. The power-supply voltage of this chip was set to 3.3 V, thereby reducing the dissipation power. Further, CG1, CG2, CG3, CG4 in Fig. 9 represent the potentials of the first, the second, the third, and the fourth word lines in Fig. 8. BL1, BL2, BL3, BL4 are pulses each input into nMOSFETs switches SW5 to SW8. Fig. 9 shows an example of pulses when writing is made in cell 21 in the present memory device. Before writing, the pulses BL1, BL2, BL3, BL4 from the column decoder 1 denoted by 8 are high level, low level, low level, and low level, respectively, whereby the switch SW5 is on and the other switches SW6, SW7, SW8 are off. This sets the well of the first column having the writing cell at GND potential and the well potentials of the other second to fourth columns are left in a floating state.

Further, switches SW9, SW10, SW11, SW12, SW13 are also comprised of n-type MOSFETs, and the pulses $\phi1$, $\phi2$, $\phi3$, $\phi4$, $\phi5$ are set to low level, high level, high level, high level, and low level, respectively, as shown in Fig. 9. In addition, SW1 to SW4 are comprised of p-type MOSFETs and pulses from the column decoder 2 denoted by 7 all are set to low level, whereby the source and drain electrodes of each cell are fixed at GND potential.

The row driver denoted by 9 next applies a pulse with an amplitude of 10 V only to the word line connected to the writing cell 21. In this case, the power-supply voltage is 3.3 V, but because no current flows, a high voltage can readily be made in the chip by a booster circuit. With application of the writing pulse a bias of about 6.6 V is applied between the control gate 1 and the floating gate 2 of cell 21, so that the antifuse region between the control gate 1 and the floating gate 2 of the cell changes from high-resistance state to the low-resistance state in some 10 ns, thus completing writing. Since with application of the above pulse a bias of only about 0.1 to 0.5 V is applied between the control gate and the floating gate of the cells 22, 23, 24 connected to the same word line, the regions are kept in the high-resistance state between the control gate and the floating gate without writing. The reason is that SW6 to SW8 are off to keep the well potentials of the second column, the third column, and the fourth column in the floating state and the voltage applied is applied to the well and the substrate without being applied between the control gate and the floating gate. After completion of writing, the word line potential is returned to O V as shown in CG2 of Fig. 9.

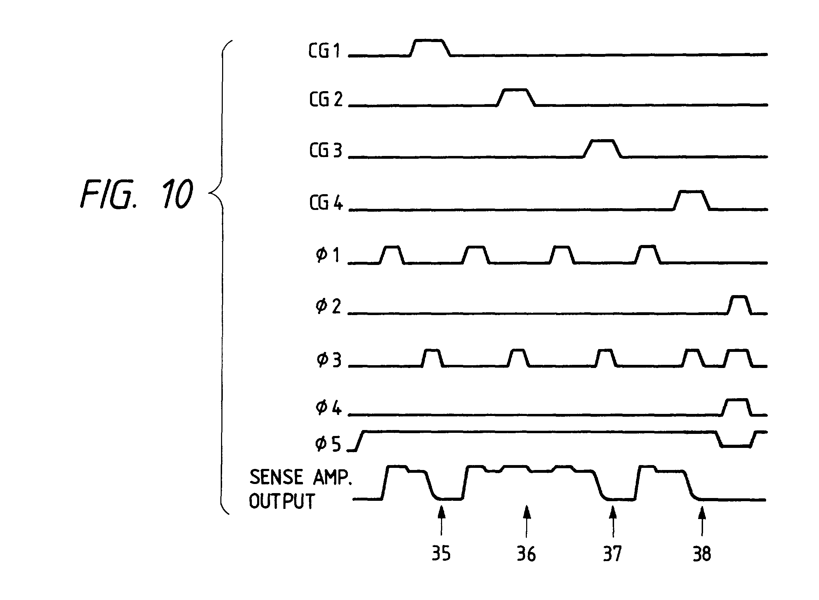

A reading operation is next explained using the schematic timing chart shown in Fig. 10. The transistor forming each cell is a p-type MOSFET, and a threshold value thereof is set to -1.8 V. Although in this example the cells are p-type MOSFETs, it is a matter course that n-type MOSFETs cells could be provided instead.

Let us suppose that the reading column is the first column in Fig. 8, that writing was done only in cell 21 in this column, and that no writing was done in the other cells 11, 31, 41.

To read the information in the first column, the column decoder 2 denoted by 7 applies to the gates of the respective switches such pulses as to turn transistor SW1 on and keep the other transistors SW2, SW3, SW4 off. In the reading operation, when the cell transistors are PMOS, SW12 is off, SW13 is on, and SW5 is on so as to fix at least the well potential of the reading column at the maximum potential. When the cell transistors are NMOS, the well potential fixed is the minimum potential, of course.

First, pulse $\phi 1$ is turned to the high level, thereby precharging the sources and drains of cells 11, 21, 31, 41 to $V_{CC}$ level. This is achieved when all word lines 4 are at 0 V and the PMOSFET of each cell is on. Next, the pulse $\phi 1$ is changed to low level, whereby pulse CG1 with amplitude 3.3 V is applied to the word line connected to the cell 11 in order to read the cell 11, as shown in Fig. 10. Since the cell 11 is a cell without written information, the floating gate potential is 1.1 V determined by capacitance division of the control and floating gate capacitance. The threshold value of this p-type MOSFET is -1.8 V as described above, and the PMOSFET of cell 11 is kept on even with application of the above pulse. Accordingly, since with application of pulse $\phi 3$ the p-type MOSFETs in the first column are all on, the output of the sense amplifier 15 is lowered as shown by 35 in Fig. 10, which teaches that the cell 11 includes no written information. Next, after again applying the pulse $\phi 1$ to effect precharge, the pulse CG2 is changed to high level in order to read the cell 21. Since the amplitude is 3.3 V and this cell 21 includes written information, the control gate and the floating gate are connected in the low-resistance state, and the voltage of 3.3 V is applied as it is. Therefore, the p-type MOSFET of cell 21 becomes off. The output of the sense amplifier is thus kept at the high level with application of the pulse $\Phi 3$, as shown by 36 in Fig. 10, which indicates that information is written in the cell. Repeating the above operation, it is found out that the outputs of cells 31, 41 are at low level as shown by 37, 38 in Fig. 10, indicating no written information therein.

After completion of reading the pulses $\Phi 2$ $\Phi 3$, $\Phi 4$ are set to high level and the pulses $\Phi 1$, $\Phi 5$ to low level, whereby not only the control gates of the cells, but also the source, the drain, and the well are set to 0 V. This makes the floating gate potentials stable at 0 V of the initial state, thus preventing occurrence of malfunction. Namely, at standby, the source, drain, control gate, and well are all at 0 V, and even with a little flow of leak current to the floating gates they are always reset automatically to 0 V, thereby keeping the operation stable.

More stable writing can be done by satisfying the following relations:

$$\{ C_{FG}/(C_{FG}+C_{CG})\} \circ V_1 \geq V_{BD} \,,$$

$$\{ C_{CG}/(C_{FG}+C_{CG})\} \circ V_2 < V_{th} \,,$$

$$V_2 > V_{th};$$

where VBD is the voltage between the floating gate 2 and the control gate 1 when the resistance value between the floating gate 2 and the control gate 1 changes from the high-resistance state into the low-resistance state, $V_{th}$ is the MOSFET threshold voltage, $C_{FG}$ is the capacitance formed between the floating gate 2 and the source region, the drain region, and the well region of the MOSFET, $C_{CG}$ is the capacitance formed between the floating gate 2 and the control gate 1, and $V_1$, $V_2$ are the writing and reading voltages respectively applied to the control gate.

As apparent from the relations of the above equations, there are the following three possibilities of decreasing the writing voltage $V_1$.

(1) To decrease $V_{BD}$. This can be achieved by decreasing the separation (T) of the proximate portion between the control gate and the floating gate.
(2) To decrease $C_{CG}$. This can be achieved by decreasing the area of the proximate portion between the control gate and the floating gate. To increase the thickness of the proximate portion between the control gate and the floating gate increases $V_{BD}$, which is thus not preferred in order to decrease the voltage $V_1$.
(3) To increase $C_{FG}$. This can conceivably be achieved by decreasing the thickness or increasing the area between the floating gate and the source region, the drain region, and the well region of MOSFET. This, however, causes such influence as to change the performance characteristics of each cell to decrease the operation speed, and to increase the element area.

In view of the cell operation and the degree of integration, to decrease $V_{BD}$ and $C_{CG}$ in combination of (1) with (2) is suitable for decreasing the writing voltage $V_1$.

From the equations described above, it is understood that the relation of $C_{CG} < C_{FG}$ is desired to be satisfied in order to decrease the writing voltage $V_1$.

The memory array described above has the following excellent points:

(i) The memory structure is simple, and the area of each cell is determined only by the word line and the patterning accuracy of Si active layer. Thus, the area of one cell without contact can be made equal to or smaller than those of the conventional memories, whereby the bit cost can be reduced.

(ii) The number of masks necessary for forming this structure is about half of that necessary for DRAM, SRAM, or flash memory, which permits a further cost reduction. Since the steps are easy, the problems of dust, and pattern defects, rarely occur, which increases the yield.

(iii) Writing operation is based on breakdown of the insulator layer between the first and second polySi layers. The withstand voltage of polySi oxide film is lower than that of C-Si oxide film, and the withstand voltage can be controlled very well and stably to a desired value by combination with new process techniques such as chemical oxidation or oxygen doping. Accordingly error rate can be very low.

(iv) In addition, the written information is permanent. This obviates needs to connect a power supply to the memory and to perform complex operations, such as refresh operations.

(v) The time necessary for writing is some 10 ns or less, and thus the writing speed is very high, which enables very good system matching.

(vi) Since the reading and writing states are not so dependent on the environmental conditions (flash memory & DRAM, for example, are strongly dependent on leak current), applications can include wide variations.

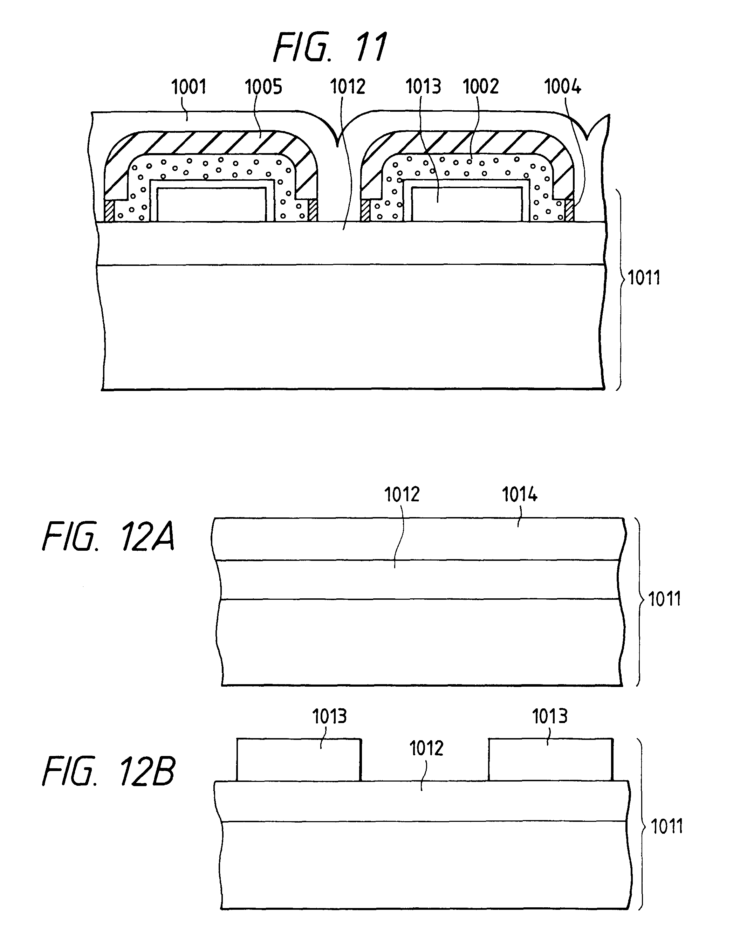

Another preferred embodiment of the memory array of the present invention is next explained referring to Fig. 11. The above-described embodiment used an Si wafer as a substrate, whereas this embodiment uses an SOI substrate. Fig. 11 shows a diagrammatic sectional structure (corresponding to Fig. 1) of part of the memory cell array. The same features will be denoted by the same reference numerals as those in Fig. 1 to Fig. 7B used in the foregoing description, and an explanation of the same features will be omitted. Numeral 1011 designates the SOI substrate, which may be any SOI wafer of good quality, for example selected from SIMOX, cemented SOI wafer, SOI wafer fabricated by forming a porous layer on a surface of Si, forming an epitaxial layer on the porous surface, cementing the wafer with the epitaxial film formed on the porous surface to a wafer having an insulating layer surface, and removing the porous layer. The conduction type of the substrate may be either n-type or p-type, and the essential point is to control the bias of the substrate so as not to turn on a parasitic MOS transistor (which is a MOS transistor occurring when the oxide film of 1012 acts as a gate insulating layer) formed above the SOI oxide layer 1012. Channel portions of cell portions each are separated in island patterns, as shown by 1013, and the floating gates 1002 cover the channel portions.

This increases the capacitance $C_{FG}$ formed between the channel 1013 and the floating gate 1002, which can result in a decrease of the voltage $V_1$ required for writing. Namely, in this example the insulating layer between the channel 1013 and the floating gate 1002 is also formed at the side surfaces of the channel 1013, as shown in Fig. 11. Therefore, the capacitance $C_{FG}$ is greater than that in the example shown in Fig.1, which results in increasing the fraction $C_{FG}/(C_{FG} + C_{CG})$ in the above equation. This can allow a decrease of the voltage $V_1$ applied to the control gate for writing. Since the effective channel regions can be formed larger, the MOS transistor performance can be enhanced. The regions between channels are perfectly insulated and separated, which can stabilise the operation.

Since in the structure of this embodiment the layer below each of the channel portions (corresponding to the wells of the previous embodiment) is the insulating layer, the capacitance of the channel portion is smaller than in the case of using a bulk substrate. This decreases the voltage between the control gate and the floating gate in non-writing bits upon writing, which rarely causes a writing error and which increases margins of the structure process.

A difference of the fabrication process of this embodiment from the previous embodiment is next briefly described referring to Fig. 12A and Fig. 12B. A different point of the process for forming the memory array of this embodiment from the previous embodiment is only that the channel portions 1013 are separated by patterning. The other parts can be formed in the same manner as in the steps shown in Fig. 4A to Fig. 7B in the previous example.

In more detail, this embodiment includes patterning by the ordinary photoetching process of a Si layer 1014 of the SOI wafer shown in the diagrammatic sectional view of Fig. 12A, thereby obtaining the shape in which the Si layer to become the channel portions 1013 is left in island patterns as shown in the diagrammatic sectional view of Fig. 12B. After that, the structure shown in Fig. 11 can be obtained by the same steps described with reference to Figs. 4A to 7B.

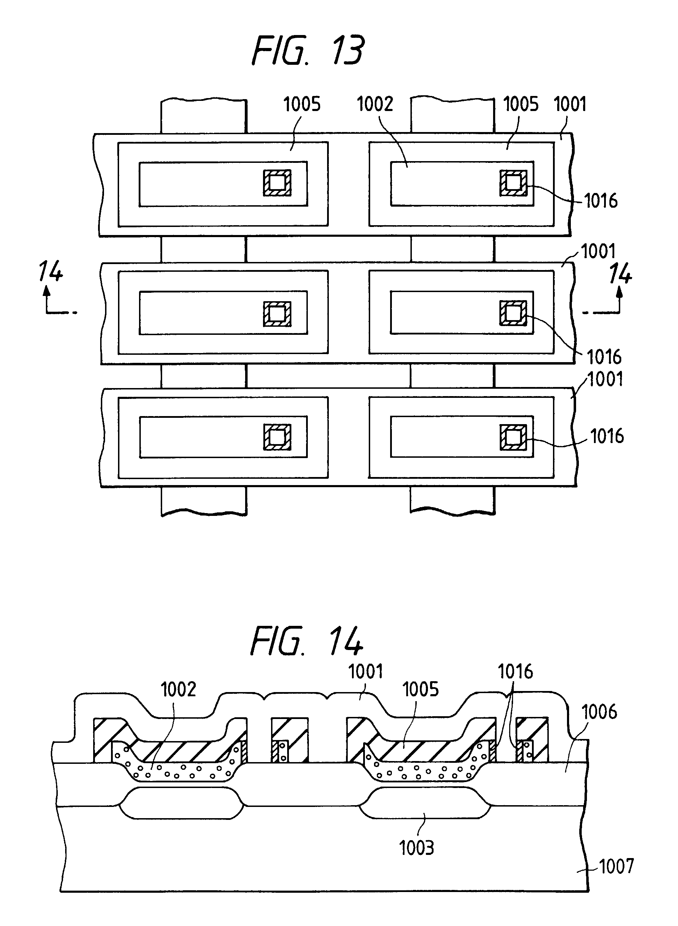

Still another embodiment is shown in Figs. 13 and 14. Fig. 13 is a diagrammatic plan view, corresponding to Fig. 2, and Fig. 14 is a diagrammatic sectional view, corresponding to Fig. 1, as a cross section of part of the array taken along section line 14-14 in Fig. 13. This embodiment is arranged in such a manner that the high-resistance thin film 1016 is formed in an inner region of each floating gate 1002. By this, the floating gates 1002 can be formed in isolated patterns from each other by preliminary patterning and thereafter the surfaces thereof all can be covered by the insulating layer 1005. After that, an opening is formed in each floating gate and the high-resistance thin film 1016 is formed on the side wall surface of the floating gate exposed by each opening, thereby obtaining the memory array shown in part in Figs. 13 and 14. The fabrication process as explained in the previous embodiments can be applied to the steps after formation of the high-resistance thin film 1016.

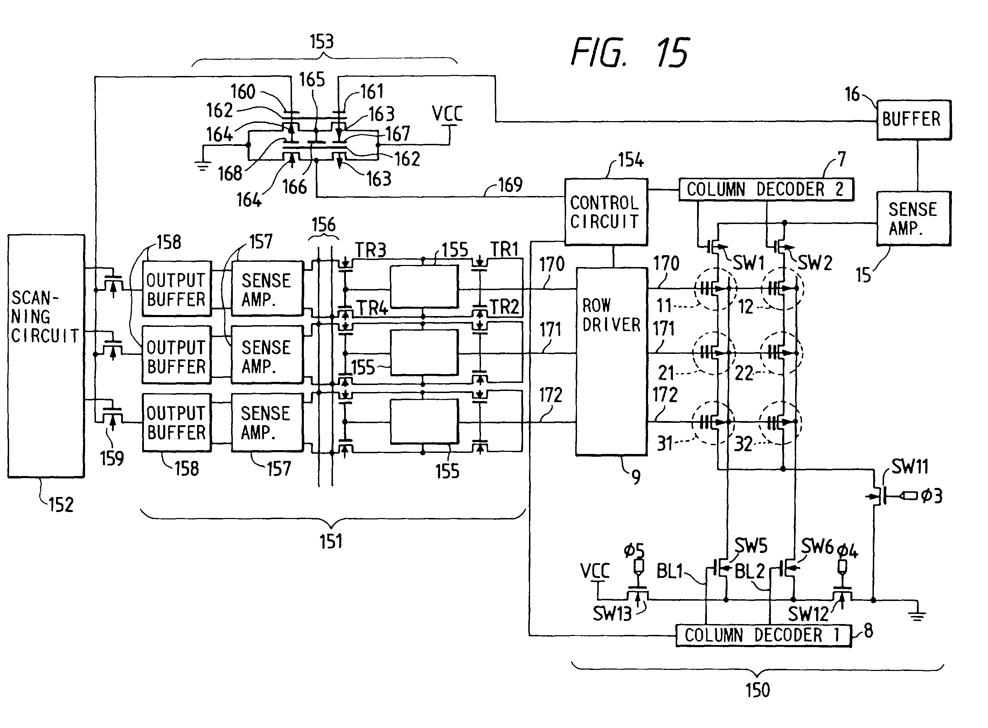

Another example of memory device is next explained using Fig. 15. The same features will be denoted by the same reference numerals as those used previously, and explanation thereof will be omitted. Numeral 150 designates a memory array as described previously, 151 an SRAM, 152 a scanning circuit for sequentially reading data from SRAM 153 an EXOR circuit for checking whether the reading result of the memory array is correct or not, and 154 a control circuit for receiving an output from the above EXOR circuit to control the drive of the memory array. Numeral 155 denotes CMOS-type SRAM memory cells, for which the p-type MOS load form is suitable because of its low dissipation power. TR1, TR2, TR3, TR4 are MOS switches for controlling drive of SRAM memory cells, 156 is common data lines, 157 is sense amplifiers, 158 is output buffers, 159 is switches for selecting outputs of the output buffers, 160, 161, 166, 167, 168 are gates input through floating gates 162 to CMOS inverters, 163 is a p-type MOS transistor, and 164 is an n-type MOS transistor. Numeral 165 denotes an output of the first-step CMOS inverter, which is input to the gate denoted by 166 of the second-step CMOS inverter. Numeral 169 is an output of the second-step CMOS inverter, which is input to the above control circuit 154. Numerals 170, 171, 172 are word lines, which are arranged in common to the memory cell array and the SRAM memory.

An operating method is next explained. Data is written in a desired column of memory 150 and the same data as in this column is also written in the cells of SRAM 151. Next, memory 150 is changed into the reading mode to sequentially read the data of the above column out by the sense amplifier 15. In synchronization with it, the scanning circuit 152 reads corresponding bits through the sense amplifiers 157 out of the SRAM cells, and the thus read-out outputs are input into the gate 160 of the EXOR circuit 153. The output of the circuit denoted by 153 is at high level when values input into the gates 160 and 161 are different but at low level when they are equal, whereby it can be checked whether information is correctly written in the memory portion 150 and correctly read, using the output from the circuit 153.

The EXOR circuit denoted by 153 is a CMOS circuit having multiple input gates through floating gates, which can be fabricated in the same structure as the memory 150 and which can perform high-functional processing with a small number of transistors. This example is arranged to execute the EXOR logic operation, but the example may be modified in such a manner that input gates of 8-bit inputs are provided through floating gates to form CMOS inverters, similar to the above example, which enables to perform majority logic of input data with two transistors (n-type MOS and p-type MOS). Using this majority logic, parity checking can be done between the 8-bit parity of input data and 8-bit parity of reading data.

The operation of Fig. 15 is further explained. When malfunction is confirmed by the output result 169, the above SRAM data is rewritten in the next column of the memory 150. This makes it possible to execute correction operation for correcting a writing error or a reading error.

Further, at least one bit in the data column is assigned as an error check bit.

In Fig. 15 SRAM has a memory capacity corresponding to one column of the memory 150, but the memory capacity thereof is by no means limited to this. For example, the memory capacity may be increased to that of a buffer memory, thereby enabling high-speed random access and writing. Although the use of SRAM has been described, it is a matter of course that the above operation may be performed using DRAM or flash memory instead, on the same chip.

The setup of the example as explained above has the following advantages:

(i) The error rate is very low;
(ii) Whether writing is correct or not can be checked on the chip ;
(iii) The logic circuit for checking can be fabricated having much the same structure as that of the memory cells of the memory array and without needing a new process ;
(iv) The above logic circuit can be constructed of a smaller number of transistors than the ordinary logic circuits, and peripheral circuits thereof can be realized in a small area, thus achieving low cost but high function ; and
(v) The device includes memory (SRAM, DRAM, flash memory, or the like) having a memory structure different from the memory structure of the memory array, able to realise high-speed random access and writing.

Next explained is an example in which memory arrays of the present invention are incorporated in an external memory card (PC card) for personal computers etc.

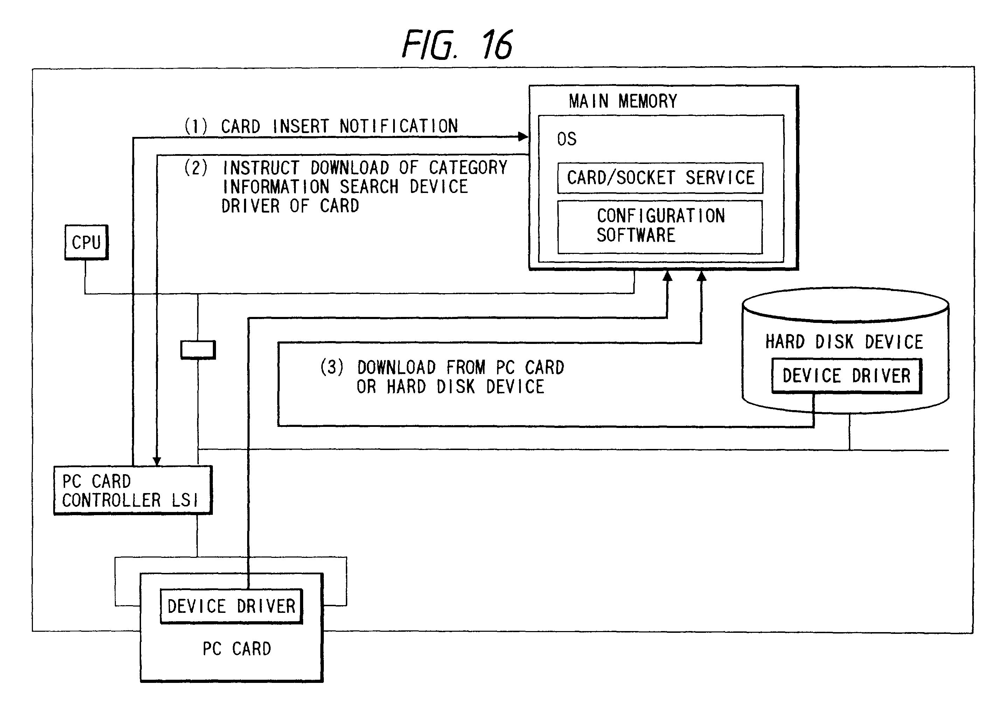

Fig. 16 is a drawing to show a relation between the card and the system when the present invention is applied to the PC card.

In the case of PC-card-ready notebook personal computers and portable information communication devices presently available, a device driver of the PC card used is resident in the main memory. When the personal computers and the portable information communication devices are ready for plural types of PC cards, the capacity used increases for storage of the device drivers preset in the main memory portion, and some application softwares could become incapable of operating because the capacity for the drivers is too large.

The card constructed using memory arrays of the present invention leaves enough space for a ROM to be included on chip. Accordingly, this card may store information re.. the device driver thereof and CIS (card-information-structure), which is information re. the type of card, capacity, identification of card, and configuration, and it may be provided with a function to execute download in accordance with notification of card insertion of and an instruction of device driver download when the card is inserted into the main body, as shown in Fig. 16.

The interface between the card and the main body is according to the formats of PCMCIA (the canonicalization institute of United States of America) and JEIDA (Japan Electronic Industry Development Association), available for 68-pin connector, the data bus width 32 bits, the clock frequency 16 MHz, the maximum data transfer rate 60 Mbyte/s, etc.

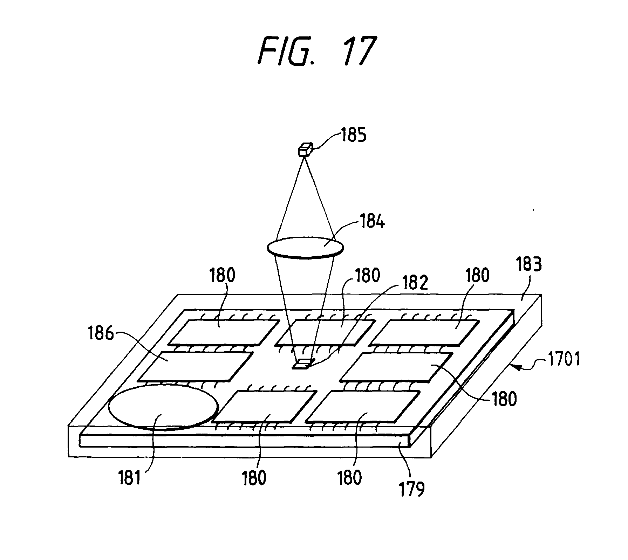

Next explained referring to Fig. 17 is an example of IC card for input and output of information by light. Each numeral 180 designates a memory device incorporating a memory array of the present invention, 181 a battery, 182 a semiconductor laser and a photodetector as input and output means for input and output, 186 a control circuit for controlling the memory apparatus, the laser, and the photodetector mounted on a board 179, 183 a transparent or partially transparent plastic package for protecting the foregoing devices, 184 an optical system such as a lens, and 185 a semiconductor laser and a photodetector. The IC card 1701 is arranged in such a manner that the light is used for transmission of information necessary for the IC card to communicate with the outside, such as writing data, reading data, control clock, etc. and all other operations are carried out by the control circuit 186 mounted on the board 179.

Although not shown clearly in Fig. 17, the card has an alignment mark for positioning the optical system on the board 179. When this IC card is set in a writing and reading apparatus for using this card, it can be set at a desired position quickly.

This IC card has the following advantages.

(i) This card is free of the problem of contact error of connection pins and problem of reliability of pins, different from conventional IC cards, and has high reliability.
(ii) Since the IC card is packaged in a transparent plastic package formed by simple integral molding, it can be realized at very low cost.

(iii) The modulation frequency of the semiconductor laser is high, so that input and output of information can be carried out at a high bit rate and the power can be decreased.

A memory device may be arranged to include a programmable logic array constructed in such an arrangement that the first polySi layer forming the floating gates and the second polySi layer forming the word lines in the memory array of the present invention are arranged in a matrix, many AND circuits and OR circuits are arranged, and logic may be freely set in accordance with a use purpose of each user by changing regions between the lines at intersecting points of the matrix from high-resistance state to low-resistance state so as to substantially connect the lines to each other. The portions to be changed to low-resistance state between the lines can be changed to low-resistance state by applying a bias to the lines arranged in the matrix.

When this programmable logic array is built in the memory device, operations according to user's specifications can be realized without change of mask, which can further decrease the cost and which can reduce the supply period to the user.

**Claims**

1. A one-time programmable read-only memory (OT-PROM) array having a plurality of memory cells (11-13, 21-23, 41-43) provided on a substrate (1007; 1011), each memory cell having:

   a source and a drain (1008) with a channel (1003) extending therebetween;
   a floating gate (1002) overlying and insulated from said channel;
   an intergate insulation layer (1005) overlying said floating gate; and
   a control gate (1001) overlying said intergate insulation layer;
   which memory array is characterised in that:
   each memory cell (11-13, 21-23, 41-43), has an anti-fuse region (1004; 1016) defined by a high resistance thin film, interposed between said control gate (1001) and said floating gate (1002), on

   (a) one or both of the edge surfaces of said floating gate which extend in a direction parallel to said channel, or
   (b) the sidewall surface of said floating gate located in an opening provided in said intergate insulation layer and in said floating gate.

2. An array according to claim 1, wherein said thin film has a thickness ($t_1$) in the range 1 to 30nm.

3. An array according to claim 2, wherein said thin film has a thickness in the range 3 to 20nm.

4. An array according to claim 3, wherein said thin film has a thickness in the range 5 to 15nm.

5. An array according to any preceding claim, wherein said thin film is of silicon oxide, silicon nitride or silicon oxynitride.

6. An array according to any preceding claim, wherein said thin film is of an insulator material containing tantalum (Ta).

7. An array according to claim 6, wherein said thin film is of tantalum oxide.

8. An array according to any preceding claim, wherein said floating gate is of polysilicon.

9. An array according to claim 8, wherein metal is contained in said polysilicon.

10. An array according to claim 9, wherein said metal is a refractory metal.

11. An array according to any of claims 1 to 7, wherein said floating gate is of refractory metal.

12. An array according to either of claims 10 or 11 wherein said refractory metal is at least one of the metals tungsten, titanium, tantalum or molybdenum

13. An array according to any of claims 1 to 7, wherein said floating gate is of silicide or polyside material.

14. An array according to any preceding claim, wherein said thin film is the oxidation or nitridation product of a process in which (a) one or both said edge surfaces, or (b) said side wall surface, of said floating gate are treated by oxidation or nitridation.

15. An array according to any preceding claim wherein said substrate (1011) comprises a silicon semiconductor layer (1014) on an insulator layer (1012), said memory cell having said source, drain, and channel provided in a respective portion (1013) of said semiconductor layer.

16. An array according to any preceding claim wherein in each memory cell the capacitance between said floating gate and the substrate is greater than the capacitance between said floating gate and said control gate.

17. An array according to any preceding claim wherein in each memory cell said floating gate is insulated from said channel by an insulation layer (1006) of silicon oxynitride.

18. An array according to any preceding claim wherein said plurality of memory cells are arranged in a matrix of rows and columns, the memory cells (11, 21, 31; 14, 24, 34) in each column being arranged in series with their respective source (5) electrically connected to the drain (6) of the preceding memory cell (21, 31, 41; 24, 34, 44).

19. An array according to any preceding claim wherein said substrate (1007) is a bulk semiconductor substrate, said plurality of memory cells are arranged in a matrix of rows and columns, the drain (6), source (5) and channel of each memory cell (11, 21, 31, 41; 14, 24, 34, 44) in respective columns are defined in a respective common well (1003) electrically insulated from the common wells of adjacent columns; and respective conductive lines (4) are connected to the control gate (1) of each memory cell in respective rows (11, 21, 31, 41; 14, 24, 34, 44).

20. An array according to any preceding claims 1 to 18, wherein said substrate (1011) is a semiconductor-on-insulator substrate, said plurality of memory cells are arranged in a matrix of rows and columns, the drain (6), source (5), and channel of each memory cell (11, 21, 31, 41; 14, 24, 34, 44) in respective columns are defined in respective separated islands (1013) of the semiconductor layer (1014) of said semiconductor-on-insulator substrate, and respective conductive lines (4) are connected to the control gate (1) of each memory cell (11, 21, 31, 41; 14, 24, 34, 44) in respective rows.

21. A programmed read-only memory array consisting of a memory array according to any preceding claim, wherein said antifuse region (1004, 1016) of selected memory cells, amongst said plurality of memory cells, are each in a fused low-resistance state, a respective conductive path thus being provided between the respective floating gate and respective control gate of each respective selected memory cell.

22. A programmable read-only memory device comprising:

an OT-PROM memory array according to any preceding claim 1 to 20;
means (8, 9, 25) of addressing and writing data to selected memory cells amongst said plurality of memory cells; and
means (7, 9, 15, 16, 25) of addressing and reading data from each memory cell amongst said plurality of memory cells.

23. A device according to claim 22, wherein the memory cells of said OT-PROM memory array are arranged in a matrix of columns and rows, said device further including:

a random access memory (155),
means (TR3, TR4) of writing data to said random access memory, the data which is to be written therein being the same data which is to be written to memory cells in a column of said OT-PROM memory array;
means (TR1, TR2) of reading data from said random access memory;
means (153) of collating data read from said random access memory with data read from said memory cells in said column of said OT-PROM memory array for outputting a collation result to indicate whether or not the collated data is the same or is different;
means (7, 9, 154) of writing said collation result in at least one other memory cell in said column of memory cells; and
means (7, 9, 154) of rewriting said data in memory cells of a next column of said OT-PROM memory array if said collation result indicates that the collated data is different.

24. A device according to claim 23, wherein said random access memory is a CMOS SRAM.

25. A device according to any of claims 22 to 24, including input means for receiving signals from an external device.

26. A device according to claim 25, wherein said input means comprises a photodetector.

27. A device according to either of claims 25 or 26, including output means for transmitting signals to an external device.

28. A device according to claim 27, wherein said output means comprises a semiconductor laser.

29. A programmed memory device comprising:

a programmed memory array according to claim 21; and
means of addressing and reading data from each memory cell amongst said plurality of memory cells.

30. A method of recording information comprising steps of:

providing the one-time programmable read-only memory of claim 1; and
in accordance with the information that is to be recorded, applying a first voltage $V_1$ to the control gate (1001) of selected memory cells to change, in each respective selected memory cell, the resistance value of the respective anti-fuse region (1004;1016) from that of the high resistance thin film, to a lower value, affording electrical connection between the respective control gate (1001) and the respective floating gate (1002) of the respective selected memory cell.

31. A method according to claim 30 wherein, for the recording of information in a selected memory cell, the channel (1003) thereof is held at a supply voltage or at ground potential (GND) while the channels (1003) of non-selected memory cells are left at a floating voltage.

32. A method according to claim 31 wherein information recording is performed under the following conditions:

$$\{ C_{FG}/(C_{FG}+C_{CG})\}^{\circ} V_1 \geq V_{BD} \,,$$

$$\{ C_{CG}/(C_{FG}+C_{CG})\}^{\circ} V_2 < V_{th} \,,$$

$$V_2 > V_{th};$$

where $V_{BD}$ is the voltage between the respective floating gate (1002) and the respective control gate (1001) of the respective selected memory cell when the resistance value of the respective anti-fuse region is changed from its high resistance thin film value to said lower resistance value, $V_{th}$ is the threshold voltage of the respective memory cell, $C_{FG}$ is the capacitance defined between the respective floating gate (1002) and the substrate (1007;1011), $C_{CG}$ is the capacitance defined between the respective floating gate and the respective control gate (1001), $V_1$ is the voltage applied to the respective control gate (1001) for recording, and $V_2$ is a voltage set for reading the selected memory cell, which voltage $V_2$ is to be applied to the respective control gate (1001).

**Revendications**

1. Groupement de mémoires à lecture seule programmables une seule fois (OT-PROM) comportant une pluralité de cellules (11-13, 21-23, 41-43) de mémoire disposées sur un substrat (1007 ; 1011), chaque cellule de mémoire comportant :

une source et un drain (1008), un canal (1003) s'étendant entre eux ;

une grille flottante (1002) recouvrant ledit canal et étant isolée de celui-ci ;

une couche isolante intergrille (1005) recouvrant ladite grille flottante ; et

une grille (1001) de commande recouvrant ladite couche isolante intergrille ;

lequel groupement de mémoires est caractérisé en ce que :

chaque cellule (11-13, 21-23, 41-43) de mémoire comporte une région anti-fusible (1004 ; 1016) définie par un film mince à haute résistance, interposé entre ladite grille (1001) de commande et ladite grille flottante (1002), sur

(a) l'une ou les deux des surfaces de bord de ladite grille flottante qui s'étendent dans une direction parallèle audit canal, ou

(b) la surface de paroi latérale de ladite grille flottante située dans une ouverture prévue dans ladite couche isolante intergrille et dans ladite grille flottante.

2. Groupement selon la revendication 1, dans lequel ledit film mince a une épaisseur ($t_1$) dans la plage de 1 à 30 nm.

3. Groupement selon la revendication 2, dans lequel ledit film mince a une épaisseur dans la plage de 3 à 20 nm.

4. Groupement selon la revendication 3, dans lequel ledit film mince a une épaisseur dans la plage de 5 à 15 nm.

5. Groupement selon l'une quelconque des revendications précédentes, dans lequel ledit film mince est en oxyde de silicium, en nitrure de silicium ou en oxynitrure de silicium.

6. Groupement selon l'une quelconque des revendications précédentes, dans lequel ledit film mince est fait à base d'une matière isolante contenant du tantale (Ta).

7. Groupement selon la revendication 6, dans lequel ledit film mince est en oxyde de tantale.

8. Groupement selon l'une quelconque des revendications précédentes, dans lequel ladite grille flottante est en polysilicium.

9. Groupement selon la revendication 8, dans lequel du métal est contenu dans ledit polysilicium.

10. Groupement selon la revendication 9, dans lequel ledit métal est un métal réfractaire.

11. Groupement selon l'une quelconque des revendications 1 à 7, dans lequel ladite grille flottante est faite à base de métal réfractaire.

12. Groupement selon l'une ou l'autre des revendications 10 ou 11, dans lequel ledit métal réfractaire est au moins l'un des métaux de tungstène, de titane, de tantale, ou de molybdène.

13. Groupement selon l'une quelconque des revendications 1 à 7, dans lequel ladite grille flottante est faite de matière à base de siliciure, ou de polysiliciure.

14. Groupement selon l'une quelconque des revendications précédentes, dans lequel ledit film mince est le produit de l'oxydation ou de la nitruration d'un traitement dans lequel (a) l'une ou les deux desdites surfaces de bord, ou (b) ladite surface de paroi latérale, de ladite grille flottante sont traitées par oxydation ou par nitruration.

15. Groupement selon l'une quelconque des revendications précédentes, dans lequel ledit substrat (1011) comprend une couche semi-conductrice de silicium (1014) disposée sur une couche isolante (1012), ladite cellule de mémoire comportant ladite source, ledit drain et ledit canal disposés dans une partie respective (1013) de ladite couche semi-conductrice.

16. Groupement selon l'une quelconque des revendications précédentes, dans lequel, dans chaque cellule de mémoire, la capacité entre ladite grille flottante et le substrat est plus grande que la capacité entre ladite grille flottante et ladite grille de commande.

17. Groupement selon l'une quelconque des revendications précédentes, dans lequel, dans chaque cellule de mémoire, ladite grille flottante est isolée dudit canal par une couche isolante (1006) d'oxynitrure de silicium.

18. Groupement selon l'une quelconque des revendications précédentes, dans lequel ladite pluralité de cellules de mémoire est agencée en une matrice de rangées et de colonnes, les cellules (11, 21, 31 ; 14, 24, 34) de mémoire dans chaque colonne étant agencées en série, leur source respective (5) étant connectée électriquement au drain (6) de la cellule (21, 31, 41 ; 24, 34, 44) de mémoire précédente.

19. Groupement selon l'une quelconque des revendications précédentes, dans lequel ledit substrat (1007) est un substrat semi-conducteur massif, ladite pluralité de cellules de mémoire est agencée en une matrice de rangées et de colonnes, le drain (6), la source (5) et le canal de chaque cellule (11, 21, 31, 41 ; 14, 24, 34, 44) de mémoire dans des colonnes respectives sont définis dans un puits commun respectif (1003) isolé électriquement des puits communs de colonnes adjacentes ; et dans lequel des lignes conductrices respectives (4) sont connectées avec la grille (1) de commande de chaque cellule de mémoire des rangées respectives (11, 21, 31, 41 ; 14, 24, 34, 44).

20. Groupement selon l'une quelconque des revendications 1 à 18, dans lequel ledit substrat (1011) est un substrat semi-conducteur sur isolant, ladite pluralité de cellules de mémoire est agencée en une matrice de rangées et de colonnes, le drain (6), la source (5) et le canal de chaque cellule (11, 21, 31, 41 ; 14, 24, 34, 44) de mémoire dans des colonnes respectives sont définis dans des îlots distincts respectifs (1013) de la couche semi-conductrice (1014) dudit substrat semi-conducteur sur isolant, et dans lequel des lignes conductrices respectives (4) sont connectées avec la grille (1) de commande de chaque cellule (11, 21, 31, 41 ; 14, 24, 34, 44) de mémoire dans des rangées respectives.

21. Groupement de mémoires programmables à lecture seule constitué d'un groupement de mémoires selon l'une quelconque des revendications précédentes, dans lequel ladite région anti-fusible (1004, 1016) de cellules de mémoire, choisies parmi ladite pluralité de cellules de mémoire, est dans un état fondu à faible résistance, un trajet conducteur respectif étant ainsi réalisé entre la grille flottante respective et la grille de commande respective de chaque cellule de mémoire respective choisie.

22. Dispositif de mémoire programmable à lecture seule, comprenant :

    un groupement de mémoires OT-PROM selon l'une quelconque des revendications précédentes 1 à 20 ;
un moyen (8, 9, 25) d'adressage et d'écriture de données dans des cellules de mémoire choisies parmi ladite pluralité de cellules de mémoire ; et
un moyen (7, 9, 15, 16, 25) d'adressage et de lecture de données à partir de chaque cellule de mémoire parmi ladite pluralité de cellules de mémoire.

23. Dispositif selon la revendication 22, dans lequel les cellules de mémoire dudit groupement de mémoires OT-PROM sont agencées en une matrice de colonnes et de rangées, ledit dispositif incluant en outre :

    une mémoire à accès direct (155),

des moyens (TR3, TR4) d'écriture de données dans ladite mémoire à accès direct, les données devant y être écrites étant les mêmes données devant être écrites dans des cellules de mémoire d'une colonne dudit groupement de mémoires OT-PROM ;
des moyens (TR1, TR2) de lecture de données à partir de ladite mémoire à accès direct ;
un moyen (153) de recueil de données lues à partir de ladite mémoire à accès direct, les données lues à partir desdites cellules de mémoire dans ladite colonne dudit groupement de mémoires OT-PROM étant destinées à délivrer un résultat de recueil pour indiquer si les données recueillies sont les mêmes ou si elles sont différentes ;
des moyens (7, 9, 154) d'écriture dudit résultat de recueil dans au moins une autre cellule de mémoire dans ladite colonne de cellules de mémoire ; et
des moyens (7, 9, 154) de réécriture desdites données dans des cellules de mémoire d'une colonne suivante dudit groupement de mémoires OT-PROM si ledit résultat de recueil indique que les données recueillies sont différentes.

24. Dispositif selon la revendication 23, dans lequel ladite mémoire à accès direct est une CMOS SRAM.

25. Dispositif selon l'une quelconque des revendications 22 à 24, comprenant un moyen d'entrée destiné à recevoir des signaux d'un dispositif externe.

26. Dispositif selon la revendication 25, dans lequel ledit moyen d'entrée comprend un photodétecteur.

27. Dispositif selon l'une ou l'autre des revendications 25 ou 26, comprenant un moyen de sortie destiné à émettre des signaux vers un dispositif externe.

28. Dispositif selon la revendication 27, dans lequel ledit moyen de sortie comprend un laser à semi-conducteur.

29. Dispositif de mémoire programmable comprenant :

    un groupement de mémoires programmables selon la revendication 21 ; et
des moyens d'adressage et de lecture de données à partir de chaque cellule de mémoire parmi ladite pluralité de cellules de mémoire.

30. Procédé d'enregistrement d'information comprenant les étapes, dans lesquelles :

    on utilise la mémoire de la revendication 1, à lecture seule programmable une seule fois; et
on applique, en fonction de l'information qui est à enregistrer, une première tension $V_1$ à la grille (1001) de commande de cellules de mémoire choisies pour faire varier, dans chaque cellule de mémoire respective choisie, la valeur de résistance de la région anti-fusible respective (1004 ; 1016) de celle du film mince à haute résistance, à une valeur plus faible, en permettant une connexion électrique entre la grille (1001) de commande respective et la grille flottante respective (1002) de la cellule de mémoire respective choisie.

31. Procédé selon la revendication 30, dans lequel, pour l'enregistrement d'information dans une cellule de mémoire choisie, on maintient son canal (1003) à une tension d'alimentation ou à un potentiel de masse (GND), tandis qu'on laisse les canaux (1003) des cellules de mémoire non choisies à une tension flottante.

32. Procédé selon la revendication 31, dans lequel on effectue l'enregistrement d'information dans les conditions suivantes :

$$\{C_{FG} / (C_{FG} + C_{CG})\}^{\bullet} V_1 \geq V_{BD},$$

$$\{C_{CG} / (C_{FG} + C_{CG})\}^{\bullet} V_2 < V_{th},$$

$$V_2 > V_{th} \; ;$$

où $V_{BD}$ est la tension entre la grille flottante respective (1002) et la grille (1001) de commande respective de la cellule de mémoire respective choisie lorsque l'on fait varier la valeur de résistance de la région anti-fusible respective de sa valeur de film mince à haute résistance à ladite valeur de résistance plus faible, $V_{th}$ est la tension de seuil de la cellule de mémoire respective, $C_{FG}$ est la capacité définie entre la grille flottante respective (1002) et le substrat (1007 ; 1011), $C_{CG}$ est la capacité définie entre la grille flottante respective et la grille (1001) de commande respective, $V_1$ est la tension appliquée à la grille (1001) de commande respective pour un enregistrement, et où $V_2$ est une tension fixée pour une lecture de la cellule de mémoire choisie, laquelle tension $V_2$ doit être appliquée à la grille (1001) de commande respective.

**Patentansprüche**

1. Regelmäßige einmalig programmierbare Nur-Lese-Speicheranordnung (OT-PROM) mit einer Vielzahl von auf einem Substrat (1007; 1011) bereitgestellten Speicherzellen (11-13, 21-23, 41-43), wobei jede Speicherzelle versehen ist mit:

einem Soucebereich und einem Drainbereich (1008) mit einem sich dazwischen erstreckenden Kanal (1003);
einer schwebenden Gateelektrode (1002), die über dem Kanal liegt und von diesem isoliert ist;
einer Gateelektrodenzwischenisolationsschicht (1005), die über der schwebenden Gateelektrode liegt; und
einer Steuergateelektrode (1001), die über der Gateelektrodenzwischenisolationsschicht liegt; dabei ist die Speicheranordnung **dadurch gekennzeichnet, daß**:
jede Speicherzelle (11-13), 21-23, 41-43) einen durch eine hochohmige Dünnschicht definierten Antischmelzbereich (1004; 1016) aufweist, wobei die hochohmige Dünnschicht zwischen der Steuergateelektrode (1001) und der schwebenden Gateelektrode (1002) angeordnet ist, dabei ist der Antischmelzbereich auf

(a) einer oder den beiden Eckenoberflächen der schwebenden Gateelektrode, die sich in paralleler Richtung zu dem Kanal erstreckt, oder
(b) der Seitenwandoberfläche der schwebenden Gateelektrode angeordnet, wobei der Antischmelzbereich in einer in der Gateelektrodenzwischenisolationsschicht und in der schwebenden Gateelektrode bereitgestellten Öffnung angeordnet ist.

2. Regelmäßige Anordnung nach Anspruch 1, wobei die Dünnschicht eine Dicke ($t_1$) in einem Bereich von 1 bis 30 nm aufweist.

3. Regelmäßige Anordnung nach Anspruch 2, wobei die Dünnschicht eine Dicke in einem Bereich von 3 bis 20 nm aufweist.

4. Regelmäßige Anordnung nach Anspruch 3, wobei die Dünnschicht eine Dicke in einem Bereich von 5 bis 15 nm aufweist.

5. Regelmäßige Anordnung nach einem beliebigen vorstehenden Anspruch, wobei die Dünnschicht Siliziumoxid, Siliziumnitrid oder Siliziumoxinitrid aufweist.

6. Regelmäßige Anordnung nach einem beliebigen vorstehenden Anspruch, wobei die Dünnschicht einen isolierenden, Tantal (Ta) enthaltenden Werkstoff aufweist.

7. Regelmäßige Anordnung nach Anspruch 6, wobei die Dünnschicht Tantaloxid aufweist.

8. Regelmäßige Anordnung nach einem beliebigen vorstehenden Anspruch, wobei die schwebende Gateelektrode Polysilizium aufweist.

9. Regelmäßige Anordnung nach Anspruch 8, wobei in dem Polysilizium Metall enthalten ist.

10. Regelmäßige Anordnung nach Anspruch 9, wobei das Metall ein Refraktärmetall aufweist.

11. Regelmäßige Anordnung nach einem beliebigen der Ansprüche 1 bis 7, wobei die schwebende Gateelektrode ein Refraktärmetall aufweist.

12. Regelmäßige Anordnung nach einem der Ansprüche 10 oder 11, wobei das Refraktärmetall zumindest eines der Metalle Wolfram, Titan, Tantal oder Molybdän aufweist.

13. Regelmäßige Anordnung nach einem beliebigen der Ansprüche 1 bis 7, wobei die schwebenden Gateelektrode einen Silizid- oder Polysilizidwerkstoff aufweist.

14. Regelmäßige Anordnung nach einem beliebigen vorstehenden Anspruch, wobei die Dünnschicht das Oxidations- oder Nitridationsprodukt eines Vorgangs ist, bei dem (a) eine oder beide Eckenoberflächen oder (b) die Seitenwandoberfläche der schwebenden Gateelektrode durch eine Oxidation oder Nitridation behandelt werden.

15. Regelmäßige Anordnung nach einem beliebigen vorstehenden Anspruch, wobei das Substrat (1011) eine Siliziumhalbleiterschicht (1014) auf einer Isolationsschicht (1012) aufweist, die Speicherzelle ist mit einem Sourcebereich, einem Drainbereich und einem Kanal versehen, die in einem entsprechenden Abschnitt (1013) der Halbleiterschicht bereitgestellt sind.

16. Regelmäßige Anordnung nach einem beliebigen vorstehenden Anspruch, wobei bei jeder Speicherzelle die Kapazität zwischen der schwebenden Gateelektrode und dem Substrat größer als die Kapazität zwischen der schwebenden Gateelektrode und der Steuergateelektrode ist.

17. Regelmäßige Anordnung nach einem beliebigen vorstehenden Anspruch, wobei bei jeder Speicherzelle die schwebenden Gateelektrode von dem Kanal durch eine Isolationsschicht (1006) aus Siliziumoxinitrid isoliert ist.

18. Regelmäßige Anordnung nach einem beliebigen vorstehenden Anspruch, wobei die Vielzahl von Speicherzellen in einer Matrix aus Reihen und Spalten angeordnet sind, dabei sind die Speicherzellen (11, 21, 31; 14, 24, 34) in jeder Spalte in Reihenschaltung angeordnet, wobei ihre jeweilige Sourceelektrode (5) mit der Drainelektrode (6) der vorhergehenden Speicherzelle (21, 31, 41; 24, 34, 44) elektrisch verbunden ist.

19. Regelmäßige Anordnung nach einem beliebigen vorstehenden Anspruch, wobei das Substrat (1007) ein Volumenkristallhalbleitersubstrat ist, die Vielzahl von Speicherzellen in einer Matrix aus Reihen und Spalten angeordnet sind, die Drainelektrode (6), Sourceelektrode (5) und Kanal jeder Speicherzelle (11, 21, 31, 41; 14, 24, 34, 44) in entsprechenden Spalten durch eine jeweils gemeinsame Barriere (1003) definiert sind, die von den gemeinsamen Barrieren benachbarter Spalten elektrisch isoliert ist; und entsprechende leitende Leitungen (4) mit der Steuerelektrode (1) jeder Speicherzelle in entsprechenden Reihen (11, 21, 31, 41; 14, 24, 34, 44) verbunden sind.

20. Regelmäßige Anordnung nach einem beliebigen der vorstehenden Ansprüche 1 bis 18, wobei das Substrat (1011) ein Halbleiter-auf-Isolator-Substrat ist, die Vielzahl von Speicherzellen in einer Matrix aus Reihen und Spalten angeordnet sind, die Drainelektrode (6), Sourceelektrode (5) und Kanal jeder Speicherzelle (11, 21, 31, 41; 14, 24, 34, 44) in entsprechenden Spalten durch jeweils getrennte Inseln (1013) der Halbleiterschicht (1014) des Halbleiter-auf-Isolator-Substrats definiert sind, und entsprechende leitende Leitungen (4) mit der Steuerelektrode (1) jeder Speicherzelle in entsprechenden Reihen (11, 21, 31, 41; 14, 24, 34, 44) verbunden sind.

21. Programmierte regelmäßige Nur-Lese-Speicheranordnung, die aus einer regelmäßigen Speicheranordnung gemäß einem beliebigen vorstehenden Anspruch besteht, wobei der Antischmelzbereich (1004, 1016) von ausgewählten Speicherzellen unter der Vielzahl von Speicherzellen jeweils in einem geschmolzenen niederohmigen Zustand ist, womit ein entsprechender leitender Pfad zwischen der jeweiligen schwebenden Gateelektrode und der jeweiligen Steuergateelektrode jeder entsprechenden ausgewählten Speicherzelle bereitgestellt ist.

22. Programmierbare Nur-Lese-Speichervorrichtung mit

einer regelmäßigen OT-PROM-Speicheranordnung gemäß einem beliebigen der vorstehenden Ansprüche 1 bis 20;
Einrichtungen (8, 9, 25) zum Adressieren und Schreiben von Daten in ausgewählte Speicherzellen aus der Vielzahl von Speicherzellen; und
Einrichtungen (7, 9, 15, 16, 25) zum Adressieren und Lesen von Daten von jeder Speicherzelle aus der Vielzahl von Speicherzellen.

23. Vorrichtung nach Anspruch 22, wobei die Speicherzellen der regelmäßigen OT-PROM-Speicheranordnung in einer Matrix aus Spalten und Reihen angeordnet sind, die Vorrichtung ist zudem versehen mit:

einem Speicher mit wahlfreiem Zugriff (155), Einrichtungen (TR3, TR4) zum Schreiben von Daten in den Speicher mit wahlfreiem Zugriff, dabei sind die darin zu schreibenden Daten die gleichen Daten, die in Speicherzellen in einer Spalte der regelmäßigen OT-PROM-Speicheranordnung zu schreiben sind;
Einrichtungen (TR1, TR2) zum Lesen von Daten aus dem Speicher mit wahlfreiem Zugriff;
eine Einrichtung (153), die aus dem Speicher mit wahlfreiem Zugriff gelesene Daten mit aus den Speicherzellen in der Spalte der regelmäßigen OT-PROM-Speicheranordnung gelesene Daten zum Ausgeben eines Kollationsergebnisses kollationiert, wobei das Ergebnis angibt, ob die kollationierten Daten gleich sind oder sich unterscheiden;
Einrichtungen (7, 9, 154) zum Schreiben des Kollationsergebnisses in zumindest eine andere Speicherzelle in der Spalte der Speicherzellen; und
Einrichtungen (7, 9, 154) zum erneuten Schreiben der Daten in Speicherzellen einer nächsten Spalte der regelmäßigen OT-PROM-Speicheranordnung, falls das Kollationsergebnis anzeigt, daß sich die kollationierten Daten unterscheiden.

24. Vorrichtung nach Anspruch 23, wobei der Speicher mit wahlfreiem Zugriff ein CMOS-SRAM ist.

25. Vorrichtung nach einem beliebigen der Ansprüche 22 bis 24, die Eingabeeinrichtungen zum Empfangen von Signalen einer externen Vorrichtung beinhaltet.

26. Vorrichtung nach Anspruch 25, wobei die Eingabevorrichtung eine Photoerfassungsvorrichtung aufweist.

27. Vorrichtung nach einem der Ansprüche 25 oder 26, die Ausgabeeinrichtungen zum Übertragen von Signalen an eine externe Vorrichtung beinhaltet.

28. Vorrichtung nach Anspruch 27, wobei die Ausgabeeinrichtungen einen Halbleiterlaser aufweisen.

29. Programmierte Speichervorrichtung mit:

einer regelmäßigen programmierten Speicheranordnung nach Anspruch 21; und
Einrichtungen zum Adressieren und Lesen von Daten von jeder Speicherzelle aus der Vielzahl von Speicherzellen.

30. Verfahren zum Aufzeichnen von Informationen mit den Schritten:

Bereitstellen des einmalig programmierbaren Nur-Lese-Speichers aus Anspruch 1; und
Anlegen einer ersten Spannung $V_1$ in Übereinstimmung mit der aufzuzeichnenden Information an die Steuergateelektrode (1001) ausgewählter Speicherzellen zur Änderung des Widerstandswertes des entsprechenden Antischmelzbereiches (1004; 1016) in jeder entsprechenden ausgewählten Speicherzelle von dem der hochohmigen Dünnschicht auf einen geringeren Wert, was eine elektrische Verbindung zwischen der jeweiligen Steuergateelektrode (1001) und der jeweiligen schwebenden Gateelektrode (1002) der entsprechenden ausgewählten Speicherzelle liefert.

31. Verfahren nach Anspruch 30, wobei zur Aufzeichnung von Informationen in einer ausgewählten Speicherzelle der Kanal (1003) davon an die Versorgungsspannung angelegt oder auf Erdpotential (GND) gehalten ist, während die Kanäle (1003) der nicht ausgewählten Speicherzellen auf einer schwebenden Spannung verbleiben.

32. Verfahren nach Anspruch 31, wobei die Informationsaufzeichnung unter den nachstehenden Bedingungen durchgeführt wird:

$$\{C_{FG}/(C_{FG}+C_{CG})\}°V_1 \geq V_{BD} ,$$

$$\{C_{CG}/(C_{FG}+C_{CG})\}°V_2 < V_{th} ,$$

$$V_2 > V_{th};$$

wobei $V_{BD}$ die Spannung zwischen der entsprechenden schwebenden Gateelektrode (1002) und der entsprechenden Steuergateelektrode (1001) der jeweiligen ausgewählten Speicherzelle ist, wenn der Widerstandswert des entsprechenden Antischmelzbereichs von seinem hochohmigen Dünnschichtwert auf den geringeren Widerstandswert wechselt, $V_{th}$ die Schwellenspannung der jeweiligen Speicherzelle ist, $C_{FG}$ die zwischen der entsprechenden schwebenden Gateelektrode (1002) und dem Substrat (1007; 1011) definierte Kapazität ist, $C_{CG}$ die zwischen der entsprechenden schwebenden Gateelektrode und der entsprechenden Steuergateelektrode (1001) definierte Kapazität ist, $V_1$ die an die entsprechende Steuergateelektrode (1001) angelegte Spannung zum Aufzeichnen ist und $V_2$ eine zum Lesen der ausgewählten Speicherzelle eingestellte Spannung ist, dabei ist die Spannung $V_2$ an die entsprechende Steuergateelektrode (1001) anzulegen.

FIG. 1

FIG. 2

## FIG. 3

## FIG. 4A

## FIG. 4B

FIG. 5A

1009

1002 1005 1003

FIG. 5B

1003 1003

5A 5A

1005

1009

## FIG. 6A

## FIG. 6B

FIG. 7A

FIG. 7B

FIG. 8

*FIG. 9*

EP 0 727 822 B1

*FIG. 10*

## FIG. 11

1001  1005  1012  1013  1002  1004

1011

## FIG. 12A

1012  1014

1011

## FIG. 12B

1013  1013

1012

1011

## FIG. 13

## FIG. 14

FIG. 15

EP 0 727 822 B1

# FIG. 16

MAIN MEMORY

OS

CARD/SOCKET SERVICE

CONFIGURATION SOFTWARE

(1) CARD INSERT NOTIFICATION

(2) INSTRUCT DOWNLOAD OF CATEGORY
INFORMATION SEARCH DEVICE
DRIVER OF CARD

(3) DOWNLOAD FROM PC CARD
OR HARD DISK DEVICE

CPU

HARD DISK DEVICE

DEVICE DRIVER

PC CARD
CONTROLLER LSI

DEVICE DRIVER

PC CARD

EP 0 727 822 B1

# FIG. 17